# FASCICULE DE BREVET EUROPEEN

(11) **EP 3 465 375 B1**
(45) Date de publication et mention de la délivrance du brevet: **18.11.2020**
(21) Numéro de dépôt: 17731244.4
(22) Date de dépôt: 31.05.2017
(51) Int. Cl.: G06F 1/12, G06F 1/14, H03L 7/097

(54) **CIRCUIT D'ARBITRAGE TEMPOREL**
ZEITARBITRIERUNGSSCHALTUNG
TIME ARBITRATION CIRCUIT

(30) Priorité: 31.05.2016 FR 1670278
(43) Date de publication de la demande: 10.04.2019
(73) Titulaire: SCPTime, 38350 La Mure d'Isère (FR)
(72) Inventeur: GORGY, Maurice, 38170 Seyssinet Pariset (FR); MAZOYER, Jean-Luc, 38450 Notre Dame Des Commiers (FR); GORGY, Nicolas, 38350 Ponsonnas (FR); GUERY, Fabrice, 38450 Saint Georges De Commiers (FR)
(74) Mandataire: Talbot, Alexandre
(86) Numéro de dépôt international: PCT/FR2017/051370
(87) Numéro de publication internationale: WO 2017/207932

(56) Documents cités:
- EP-A1- 2 187 619
- US-B1- 6 466 635

## Description

### Domaine technique de l'invention

L'invention est relative à un circuit d'arbitrage temporel délivrant un signal d'horloge.

### État de la technique

Aujourd'hui, de nombreux dispositifs électroniques comportent une base de temps qui définit l'heure à l'intérieur du dispositif électronique via par exemple un code horaire. Cependant, cette base de temps n'est pas parfaite et notamment en ce qui concerne son exactitude. Selon la qualité de la base de temps, cette dernière peut dériver de plusieurs secondes par jour et de manière aléatoire, par exemple en fonction des conditions climatiques et ou de vibrations dans son environnement proche. Ce point n'est pas réellement problématique si la dérive est faible et si le dispositif électronique reste autonome et isolé.

En revanche, dans un réseau informatique, il est particulièrement important d'assurer la synchronisation des bases de temps des différents systèmes informatiques qui communiquent entre eux. Une bonne gestion du temps est notamment utile voire vitale pour la gestion des transactions dans des bases de données ou pour plus généralement le suivi des actions dans le réseau informatique. C'est pourquoi, dans de nombreux réseaux informatiques, l'heure est fixée par un signal qui impose une « heure de réseau » de référence.

Dans de nombreux domaines d'activité, il est nécessaire de posséder un signal d'horloge qui est sécurisé afin de s'assurer que les différentes actions réalisées sont conformes au bon fonctionnement d'une structure, d'une profession ou d'une organisation.

Ce signal d'horloge sécurisé apparaît très important pour la sécurisation d'un réseau informatique ou d'un système de distribution d'un code horaire présent sur un territoire national ou local. De cette manière, plusieurs intervenants peuvent interagir ensemble tout en étant en mesure de savoir chronologiquement qu'elles ont été les actions réalisées. Il apparaît également très important de maîtriser la distribution du temps par exemple dans le domaine du contrôle aérien, du transport ferroviaire, de la sécurité des transactions bancaires ou dans la gestion des infrastructures liées au transport du courant électrique.

Ce signal d'horloge sécurisé peut trouver un intérêt dans la distribution d'une heure de référence qui peut par exemple se présenter sous la forme d'une heure représentative d'une heure légale. L'heure légale est définie par un équipement strictement défini, par exemple un observatoire, et il existe un intérêt à distribuer, de manière sécurisée, une heure de référence à partir de cette heure légale.

Afin de garantir un certain niveau de sécurité, il est important que l'heure véhiculée soit vérifiée pour détecter les risques de défaillance d'un des éléments intervenant dans la fourniture d'une référence ou éventuellement les actes de malveillance.

Le document US 6,466,635 divulgue un générateur de signal d'horloge. Deux signaux sont appliqués aux entrées d'un détecteur de phase et de fréquence ce qui génère des impulsions PS1 et PS2. Si les deux signaux présents en entrée sont en phase, les impulsions ont des durées identiques. Au contraire, si les signaux sont fortement déphasés, les durées des impulsions sont très différentes. Les impulsions PS1 et PS2 atteignent un comparateur. Selon le résultat de la comparaison, le signal logique de commande se trouve dans un premier état ou dans un deuxième état.

### Objet de l'invention

Un objet de l'invention consiste à remédier à ces inconvénients, et à réaliser un circuit d'arbitrage temporel qui permet d'assurer la délivrance d'un signal d'horloge plus sécurisé.

L'invention est définie par le jeu des revendications ci-joint.

### Description sommaire des dessins

D'autres avantages et caractéristiques ressortiront plus clairement de la description qui va suivre de modes particuliers de réalisation de l'invention donnés à titre d'exemples, non limitatifs, et représentés aux dessins annexés, dans lesquels :
- la figure 1 illustre de façon schématique un mode de réalisation d'un circuit d'arbitrage temporel avec une source de synchronisation externe et une source de synchronisation interne,
- la figure 2 illustre de façon schématique un mode de réalisation d'un circuit d'arbitrage temporel avec deux sources de synchronisation externes,
- la figure 3 illustre de façon schématique un mode de réalisation d'un circuit d'arbitrage temporel avec deux sources de synchronisation externes et une source de synchronisation interne,
- la figure 4 illustre de façon schématique un mode de réalisation particulier d'un comparateur,
- la figure 5 illustre de façon schématique un mode de réalisation d'un circuit d'arbitrage temporel avec trois sources de synchronisation externes,
- la figure 6 illustre de façon schématique un mode de réalisation d'un circuit d'arbitrage temporel avec trois sources de synchronisation externes et des circuits de traitement.

### Description d'un mode de réalisation préférentiel de l'invention

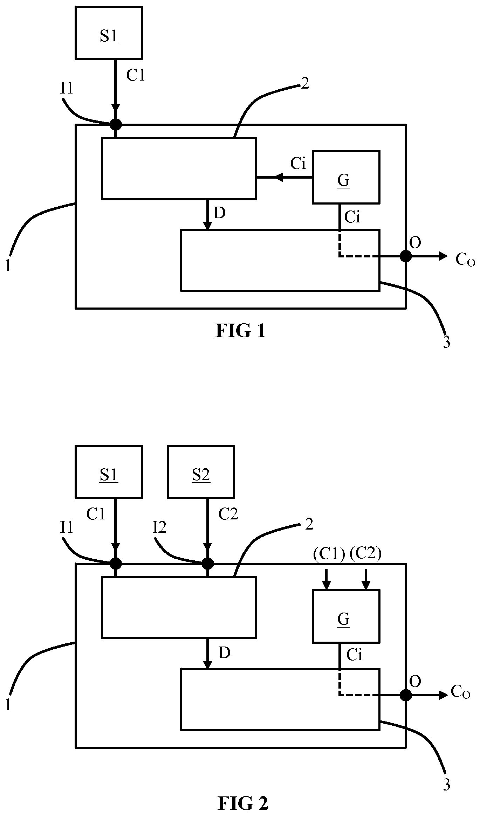

Comme illustré aux figures 1 à 6, le circuit d'arbitrage temporel 1 comporte un comparateur 2 muni d'au moins des première et deuxième entrées. Le comparateur 2 est configuré pour comparer les signaux appliqués sur les différentes entrées, par exemple des première, deuxième et éventuellement troisième entrées et pour fournir une première information D représentative de l'état de synchronisation entre les signaux présents sur les différentes entrées.

Le comparateur 2 permet de comparer les différents signaux horaires appliqués en entrée afin de détecter si ces derniers sont synchronisés ou non. Si les signaux sont synchronisés, le circuit d'arbitrage 1 peut conclure que les sources fonctionnent parfaitement et que la transmission du signal est bonne. En revanche, si au moins un des signaux est désynchronisé, le circuit d'arbitrage peut conclure que l'une des sources présente une défaillance ou est la cible d'une malveillance.

Le signal d'horloge en entrée et/ou en sortie peut être représenté sous la forme d'un code horaire ou d'un protocole horaire. Le signal d'horloge à analyser peut être composé d'un premier signal dit TOD pour Time Of Day et d'un deuxième signal dit PPS pour Pulse Per Second. La comparaison des signaux peut être décomposée en deux comparaisons pour chacune des composantes. Cependant, la criticité liée au premier signal est plus faible en comparaison de celle liée au deuxième signal car une incohérence et/ou un décalage sont plus faciles à détecter. Le signal dit PPS peut être utilisé pour définir la précision du circuit d'arbitrage. La détection d'un écart peut être réalisée, par exemple, sur la base d'un front montant.

Lorsque le signal d'horloge comporte plusieurs composantes, il est avantageux de prévoir un comparateur configuré pour fournir une première information D qui inclut des données sur la synchronisation de chacune des composantes ou de une ou plusieurs des composantes des différents signaux à comparer.

Le circuit d'arbitrage temporel 1 comporte un générateur de signal d'horloge G. Le générateur de signal d'horloge G va fournir un signal d'horloge de sortie C_{O} à une borne de sortie O du circuit d'arbitrage temporel 1. Le générateur de signal d'horloge G est interne au circuit d'arbitrage temporel 1 ce qui permet de le protéger d'actes de malveillance. La qualité du générateur de signal d'horloge G permet de définir son niveau de performance et notamment la qualité du signal C_{O} délivré par le circuit d'arbitrage temporel, par exemple la qualité de l'heure fournie par le circuit 1.

Dans un mode de réalisation privilégié, le générateur de signal d'horloge G est réalisé par un oscillateur à quartz, par exemple un oscillateur à quartz de type TCXO ou un oscillateur à quartz de type OCXO. En variante, le générateur peut être réalisé par un micro-oscillateur atomique, de préférence à base de rubidium ou de césium.

Les oscillateurs à quartz de type TCXO sont des oscillateurs thermo-compensés ce qui assure une stabilité en fréquence même si la température du milieu extérieur évolue. La stabilité en fréquence est obtenue en surveillant la température de fonctionnement de l'oscillateur électronique à quartz en fonction de la température extérieure. La plage de fonctionnement d'un tel oscillateur est comprise entre -20°C et 70°C. La stabilité en fréquence d'un tel oscillateur est de l'ordre de quelques ppm.

Les oscillateurs à quartz de type OCXO sont des oscillateurs à four qui sont configurés pour délivrer une température fixée et régulée à l'oscillateur. De cette manière, l'oscillateur est isolé des variations du milieu extérieur ce qui permet de réduire voire d'annuler les variations de fréquences liées aux variations de la température extérieure. La plage de fonctionnement d'un tel oscillateur est comprise entre -20°C et 70°C. La stabilité en fréquence d'un tel oscillateur est de l'ordre de quelques 10⁻⁸ voire quelques 10⁻⁹ pour les dispositifs les plus performants.

Les micro-oscillateurs atomiques utilisent quant à eux des propriétés physiques quasi invariantes de certains éléments chimiques afin de générer des signaux d'horloge à une fréquence très stable. Le micro-oscillateur atomique peut être à base de rubidium ou de césium. La plage de fonctionnement d'un tel oscillateur est comprise entre -40°C et 80°C. La stabilité en fréquence d'un tel oscillateur est au minimum de l'ordre de quelques 10⁻¹⁰ voire quelques 10⁻¹² pour les dispositifs les plus performants.

En variante, il est également possible d'utiliser un oscillateur ayant des performances moins bonnes que ceux précédemment cités. Il est alors nécessaire de synchroniser cet oscillateur sur un signal de référence de manière régulière. La qualité du générateur G est avantageusement liée à la performance recherchée sur le signal C_{O}. Une diminution des performances du générateur G peut être envisagée selon les besoins de l'utilisateur.

Le générateur de signal d'horloge G va délivrer le signal d'horloge Ci sur la sortie O du circuit d'arbitrage 1. Ce signal d'horloge est délivré avec un haut niveau de fiabilité car il provient d'un générateur qui est interne au circuit d'arbitrage 1. La qualité du générateur de signal d'horloge est définie en fonction des besoins de l'utilisateur, c'est-à-dire en fonction des contraintes imposées sur la dérive acceptable, pour une période de temps fixée, lorsque le générateur G n'est pas asservi, ni synchronisé à une autre source S. De manière avantageuse, le générateur G présente un niveau de performance au moins égal au niveau de la performance minimale des sources externes de synchronisation.

Le circuit d'arbitrage temporel 1 comporte encore un circuit de commande 3. Le circuit de commande 3 reçoit en entrée la première information D en provenance du comparateur 2. Le circuit de commande 3 peut être configuré pour autoriser ou bloquer la délivrance du signal d'horloge de sortie C_{O} en provenance du générateur de signal d'horloge G en fonction de l'état de la première information D. Le circuit de commande 3 peut également délivrer une information à l'utilisateur en plus ou à la place du signal C_{O}. Cette information est fonction de la première information D fournie par le comparateur 2 même si le circuit de commande 3 a décidé d'autoriser ou de bloquer la délivrance du signal d'horloge de sortie C_{O}.

Le circuit de commande 3 peut être réalisé par un microcontrôleur, un circuit logique programmable (par exemple de type FPGA pour field-programmable gâte array) ou par un dispositif logique câblé.

Dans un mode de réalisation particulier, le circuit de commande 3 comporte un interrupteur connecté entre la sortie du générateur de signal d'horloge G et la sortie du circuit d'arbitrage de manière à autoriser ou à bloquer la délivrance du signal d'horloge de sortie C_{O}. Le circuit de commande 3 autorise ou bloque la délivrance du signal d'horloge de sortie en fonction d'informations fournies par le comparateur 2. En d'autres termes, le signal C_{O} est égal au signal Ci ou est nul. En variante, le signal C_{O} peut également inclure d'autres informations par exemple des indications sur le mode de fonctionnement du circuit d'arbitrage, sur l'état des signaux de synchronisation et notamment des indications expliquant que le circuit 1 fonctionne en mode incertain car une de ses sources de synchronisation n'est pas synchronisée.

Il est particulièrement avantageux de prévoir que la première information D est obtenue au moyen de la mesure d'un écart temporel entre le signal appliqué sur la première entrée du comparateur 2 et le signal appliqué sur la deuxième entrée du comparateur 2. Le comparateur 2 est donc configuré pour mesurer l'écart temporel entre les signaux appliqués sur ses première et deuxième entrées. Cet écart temporel est typiquement de l'ordre d'une fraction de seconde. Si le signal comporte plusieurs composantes, le comparateur 2 peut être configuré pour mesurer l'écart temporel de plusieurs composantes ou de chacune des composantes.

En variante qui peut être combinée avec le mode de réalisation précédent, le comparateur 2 ou le circuit de commande 3 peut être configuré pour calculer l'évolution de l'écart temporel ou la vitesse d'évolution de l'écart temporel sur une période de temps prédéterminée.

La première source de signal S1 peut être réalisée de différentes manières et par exemple par une source unidirectionnelle. Dans un premier mode de réalisation, la première source est une source de synchronisation satellitaire et le circuit d'arbitrage temporel est relié, au moyen de sa première entrée I1, à un récepteur de type système de positionnement par satellites (ou GNSS pour Global Navigation Satellite System). Selon les modes de réalisation, le récepteur peut utiliser un seul système de positionnement par satellites tel que les systèmes GPS, GLONASS, GALILEO ou BEIDU. En variante, il est possible de prévoir que le récepteur peut utiliser simultanément plusieurs systèmes de positionnement par satellites parmi ceux cités précédemment. De manière avantageuse, le circuit d'arbitrage est synchronisé sur un signal en provenance d'un ou plusieurs satellites.

Dans un autre mode de réalisation, la première source S1 est un Protocole d'Heure Réseau (NTP pour Network Time Protocol). Ce protocole délivre une heure de référence qui permet de synchroniser une horloge à partir d'un serveur de référence. Ce signal de synchronisation C1 est appliqué sur la première entrée I1.

Dans un autre mode de réalisation, la première source S1 est un Protocole d'Heure de Précision (PTP pour Précision Time Protocol). Ce protocole constitue une évolution du protocole précédent. Ce protocole est établi selon le principe d'horloge maître et d'horloges esclaves. L'horloge maître servant de référence temporelle est appelée « horloge de référence ». Son heure est synchronisée (via GPS, NTP, etc) sur une horloge appelée horloge globale. Ce signal de synchronisation C1 est appliqué sur la première entrée I1.

Dans encore un autre mode de réalisation, la première source S1 est encore un signal électronique en provenance d'une horloge atomique.

Il est encore possible de prévoir que la première source S1 est une source qui émet un signal par onde hertzienne, par exemple un signal horaire par onde hertzienne.

À titre d'exemple, le circuit de commande 3 peut être configuré pour autoriser un décalage de 1 % entre les signaux appliqués sur les première et deuxième entrées sur une période d'une heure. Si le comparateur détecte que le décalage est inférieur à 1 %, ce dernier considère que les signaux sont synchronisés. En revanche, si le circuit de commande 3 détecte que le décalage est supérieur à 1 %, les signaux sont considérés désynchronisés et une action est réalisée par le circuit de commande 3. Les signaux sont considérés désynchronisés car la dérive d'un signal par rapport à l'autre se produit très rapidement même si en valeur absolue l'écart temporel n'a pas encore atteint une valeur seuil définie précédemment.

De manière avantageuse, si la dérive d'un signal par rapport à l'autre est très rapide, le circuit de commande 3 est configuré pour engager une action, par exemple envoyer une information sur la dérive ou la vitesse de dérive des signaux et/ou pour empêcher la synchronisation du générateur de signal G par rapport l'une des sources de synchronisation qui sont appliquées en entrée. Le circuit de commande 3 est également configuré pour suivre l'évolution du décalage entre les première et deuxième sources sur une période de temps prédéfinie. Si à la fin de la période de temps prédéfinie, le circuit de commande considère que la vitesse de dérive est trop importante, le générateur de signal d'horloge G est maintenu non asservi.

Dans un mode de réalisation particulier illustré à la figure 1, le générateur de signal d'horloge G est connecté à la deuxième entrée du comparateur 2. Le comparateur 2 émet une première information D représentative de la synchronisation entre le signal présent sur sa première entrée et le signal émis par le générateur de signal G.

Utiliser le générateur de signal d'horloge G comme une source de synchronisation apparaît comme une sécurité. En effet, le générateur de signal d'horloge G est un élément connu et dont les performances sont maîtrisées. Le générateur de signal G étant interne au circuit d'arbitrage 1, il est protégé de nombreuses perturbations extérieures et notamment des perturbations malveillantes.

De manière avantageuse, le circuit de commande 3 est configuré pour bloquer la délivrance du signal de sortie C_{O} lorsque le comparateur 2 détecte que le signal présent sur la première entrée I1 n'est plus synchronisé avec le signal d'horloge Ci émis par le générateur G. et appliqué sur la deuxième entrée Le circuit de commande 3 peut être configuré de manière à bloquer la délivrance du signal d'horloge de sortie lorsque l'écart temporel entre le signal présent sur la première entrée I1 par rapport au signal émis par le générateur G atteint une valeur seuil et/ou si la vitesse de dérive de l'écart temporel atteint une valeur seuil.

Dans cette configuration avec une seule source externe de synchronisation, le circuit d'arbitrage temporel 1 ne peut pas déterminer si l'absence de synchronisation est due à un décalage du signal émis par le générateur G ou à un décalage du signal émis par la première source S1. Afin d'éviter la délivrance d'un signal d'horloge C_{O} qui peut être corrompu, le circuit d'arbitrage temporel 1 bloque la délivrance du signal d'horloge de sortie. En alternative moins avantageuse, il est possible d'autoriser la délivrance du signal C_{O} pendant une période prédéterminée en indiquant à l'utilisateur que le signal de sortie C_{O} est dégradé. Il est également possible de combiner ces deux modes de réalisation.

Cette configuration particulière avec une source externe et une source interne n'est pas optimale car elle ne permet pas la délivrance d'un signal de sortie sécurisé pendant une longue période de temps. Il n'est pas avantageux de synchroniser le générateur G sur la source externe car une dérive lente de la source externe peut être répercutée dans le générateur.

Cependant, cette configuration peut néanmoins sembler intéressante car elle peut être utilisée comme un mode de fonctionnement dégradé pour certains des modes de réalisation à suivre lorsqu'une source de synchronisation externe a été exclue.

Dans un autre mode de réalisation illustré à la figure 2, les première et deuxième entrées du comparateur 2 sont respectivement connectées à des première et deuxième entrées I1 et I2 du circuit d'arbitrage temporel 1. Les première et deuxième entrées I1 et I2 du circuit d'arbitrage sont elles-mêmes reliées à des première et deuxième sources S1 et S2 configurées pour générer des premier et deuxième signaux d'horloge C1 et C2. La première source S1 est distincte de la deuxième source S2. Les première et deuxième sources S1 et S2 sont distinctes du générateur de signal d'horloge G.

Les première et deuxième sources S1 et S2 peuvent être choisies parmi les sources présentées pour le mode de réalisation précédent. Les sources S1 et S2 peuvent être des sources externes comme indiqué précédemment ou en variante, l'une des sources est un générateur interne qui est distinct du générateur G.

Comme dans le mode de réalisation précédent, le comparateur 2 est configuré pour détecter si les signaux C1 et C2 présents sur les première et deuxième entrées sont synchronisés ou non. Le comparateur 2 va émettre une première information D représentative de cette synchronisation. En fonction de cette information, le circuit de commande 3 va autoriser ou bloquer la délivrance du signal d'horloge de sortie C_{O} émis à partir du générateur de signal G et/ou délivrer une information relative à l'état de fonctionnement du circuit d'arbitrage.

Dans un mode de réalisation particulier, le générateur G n'est pas asservi par la première source S1, ni par la deuxième source S2 que les signaux C1 et C2 soient synchronisés ou non.

Il est particulièrement avantageux de prévoir que le circuit de commande 3 autorise la synchronisation du générateur G avec le signal émis par la première source S1 ou avec le signal émis par la seconde source S2 lorsque ces dernières sont synchronisées. Cette configuration permet de recalibrer le générateur G sur des périodes de temps importantes. Il est également avantageux de prévoir que le circuit de commande 3 empêche la synchronisation du générateur G au moyen des premier et deuxième signaux C1 et C2 lorsque ces derniers sont désynchronisés. Le générateur G est alors dans un mode non asservi, également dit « hold over ».

Ce mode de réalisation est plus avantageux que le précédent car les deux sources de synchronisation externes permettent de synchroniser le générateur G quand les sources externes sont synchronisées entre elles. Il est donc possible de suivre et de corriger une dérive du générateur G.

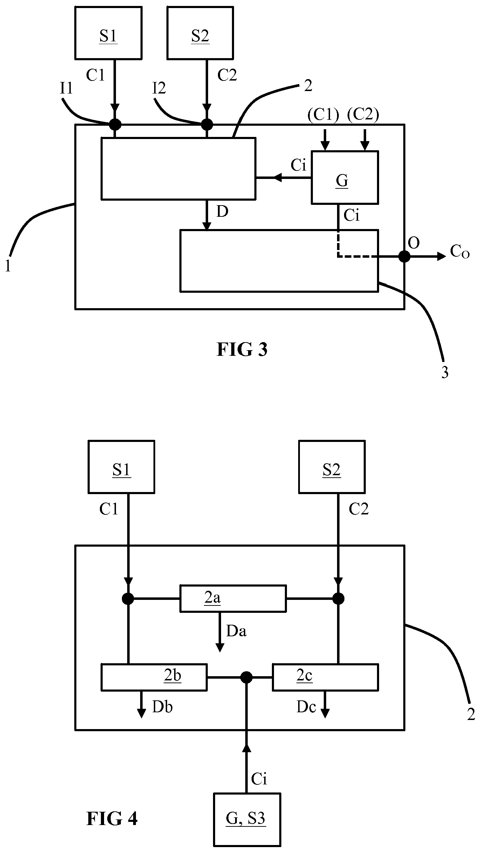

Dans un autre mode de réalisation illustré à la figure 3, le comparateur 2 comporte des première, deuxième et troisième entrées. Les première et deuxième entrées sont connectées respectivement à des première et deuxième sources S1 et S2 distinctes et qui génèrent des premier et deuxième signaux d'horloge C1 et C2. Les sources sont avantageusement des sources externes.

La troisième entrée du comparateur 2 est connectée au générateur de signal G qui intervient comme troisième source de signal, une source de synchronisation interne. Le comparateur 2 est configuré pour délivrer une première information sur l'état de synchronisation des différents signaux présents sur ses première, deuxième et troisième entrées.

Comme pour le mode de réalisation illustré à la figure 2, le générateur de signal G peut être asservi au moyen des signaux C1 et C2 dans des conditions particulières ou il peut être en mode non asservi même lorsque les signaux C1 et C2 sont synchronisés.

Dans un mode de réalisation particulier illustré à la figure 4, le comparateur 2 est divisé en comparateurs élémentaires de manière à pourvoir mesurer la synchronisation de plusieurs couples différents de signaux. Dans l'exemple illustré, le comparateur 2 est formé par trois comparateurs élémentaires 2a, 2b et 2c. Le comparateur 2a est configuré pour mesurer la synchronisation entre les signaux présents sur ses première et deuxième entrées. Le comparateur est également configuré pour mesurer séparément la synchronisation entre les signaux présents sur les deuxième et troisième entrées au moyen du comparateur 2c. Le comparateur est encore configuré pour mesurer la synchronisation entre les signaux présents sur les première et troisième entrées au moyen du comparateur 2b. Dans ce cas de figure particulier, tous les signaux sont comparés deux à deux afin de détecter la présence ou l'absence d'une synchronisation entre les différents signaux. Ce mode de régulation est particulièrement robuste car il permet de détecter rapidement un défaut de synchronisation dans l'un des signaux. Chacun des comparateurs élémentaires renvoie une information spécifique qui forme une partie de la première information D.

De manière avantageuse, le comparateur 2 est configuré pour mesurer un écart temporel entre les signaux présents sur ses première et deuxième entrées. Il est également intéressant de prévoir que le comparateur 2 est configuré pour mesurer un écart temporel entre les signaux présents sur ses deuxième et troisième entrées ainsi que sur ses première et troisième entrées. La première information D est émise au moyen des différentes valeurs des écarts temporels, ici trois écarts temporels. Dans un mode de réalisation avantageux, les écarts temporels sont comparés et le comparateur 2 ne retient que la valeur la plus importante en valeur absolue. Dans un autre mode de réalisation, les trois informations (Da, Db et Dc) sont envoyées au circuit de commande 3.

Dans un autre mode de réalisation (non représenté), tous les signaux ne sont pas comparés deux à deux. Un des trois signaux est considéré comme un signal de référence et les deux autres signaux sont comparés à ce signal de référence. Il est alors possible de vérifier que les trois signaux sont synchronisés en comparant les différents écarts temporels mesurés. De manière avantageuse, le signal de référence est défini par le générateur interne, par exemple le générateur de signal G. Ce mode de réalisation est plus compacte et moins consommateur d'énergie car un comparateur élémentaire a disparu, par exemple le comparateur élémentaire 2a.

Comme dans le mode de réalisation précédent, le circuit de commande 3 est configuré pour autoriser la synchronisation du générateur de signal G au moyen du signal présent sur la première entrée ou au moyen du signal présent sur la deuxième entrée, si ces signaux sont considérés comme synchronisés. Lorsque les signaux sont désynchronisés, le circuit de commande 3 empêche la synchronisation du générateur G au moyen des signaux C1 et C2.

Ce mode de réalisation est plus avantageux que les précédents car il utilise trois sources de synchronisation dont une source de synchronisation interne, ici le générateur G. Il est donc possible de discriminer rapidement une défaillance dans une source externe et également de synchroniser la source interne sur une période de temps importante tant que les sources externes sont synchronisées.

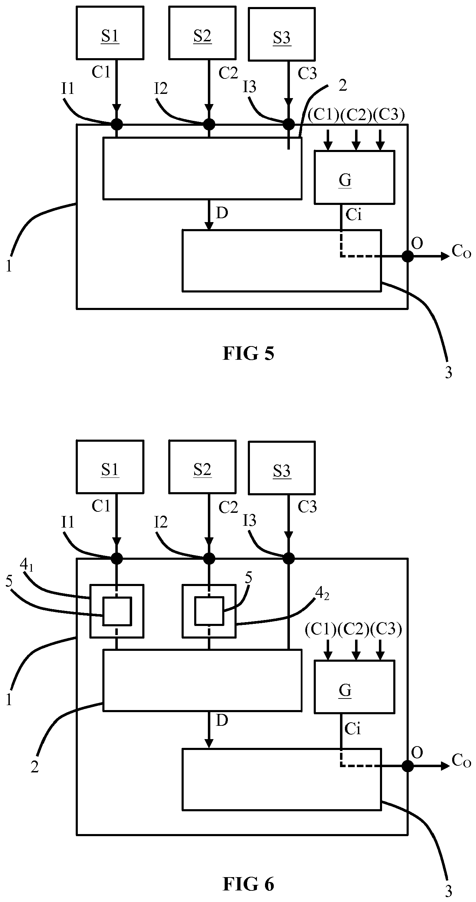

Dans un autre mode de réalisation particulier illustré à la figure 5, le comparateur 3 comporte des première, deuxième et troisième entrées qui sont respectivement connectées à des première, deuxième et troisième sources S1, S2 et S3 qui génèrent des premier, deuxième et troisième signaux d'horloge C1, C2 et C3.

Le comparateur 2 est configuré de manière à fournir une première information D relative à l'état de synchronisation des différents signaux C1, C2 et C3 appliqués en entrée. Comme indiqué précédemment, le comparateur 2 peut être configuré pour tester deux à deux tous les signaux appliqués en entrée. En variante, le comparateur peut être configuré pour tester seulement deux couples différents de signaux.

Le générateur de signal G est distinct des première, deuxième et troisième sources générant les trois signaux d'horloge différents C1, C2, C3.

Dans un mode de réalisation particulier et avantageux, l'une des sources de signal d'horloge est une source interne au circuit d'arbitrage temporel 1. Cette source interne peut être choisie parmi les exemples de sources décrits précédemment pour le générateur du signal G.

Les deux autres sources sont avantageusement des sources externes qui sont choisies parmi les exemples de sources décrits plus haut. Avantageusement, l'une des sources reçoit un signal satellitaire et l'autre des sources reçoit un signal filaire par exemple un signal de synchronisation réseau NTP ou PTP. Il est avantageux de choisir une source en provenance d'un dispositif délivrant une heure légale.

Il peut être particulièrement avantageux de prévoir que le circuit de commande 3 autorise la synchronisation du générateur de signal G avec le signal présent sur la première entrée, sur la deuxième entrée ou sur la troisième entrée du comparateur 2 lorsque le comparateur 2 détecte que les trois signaux sont synchronisés.

Lorsque le circuit de commande 3 détecte une absence de synchronisation entre les différentes sources de synchronisation S1, S2 et S3, il décide d'empêcher la synchronisation du générateur G avec ces trois sources. Dans ce cas de figure, le générateur de signal d'horloge n'est plus asservi, il est dit en mode « hold over ».

Dans un mode de réalisation particulier illustré à la figure 6, le circuit d'arbitrage temporel 1 comporte un premier circuit de traitement 4₁ qui est connecté entre la première entrée I1 du circuit d'arbitrage temporel 1 et la première entrée du comparateur 2.

De manière avantageuse, le circuit d'arbitrage temporel 1 comporte également un deuxième circuit de traitement 4₂ qui est connecté entre la deuxième entrée I2 du circuit d'arbitrage temporel 1 et la deuxième entrée du comparateur 2.

Pour comparer des signaux d'horloge, le circuit d'arbitrage temporel 1 est avantageusement configuré pour utiliser un signal top seconde. La comparaison se fait en comparant plusieurs tops de plusieurs sources horaires. Il est possible d'en déduire des valeurs moyennes d'écart. Cependant, cette comparaison ne peut se faire efficacement et de manière instantanée qu'au moyen de signaux de bonne qualité.

Le circuit de traitement 4₁, 4₂ comporte un oscillateur 5 qui est asservi au signal présent sur son entrée associée. Le signal présent sur l'entrée du comparateur 2 est donc émis à partir de l'oscillateur 5 du circuit traitement 4₁, 4₂.

Les signaux émis à partir des sources externes sont souvent bruités. Il est donc particulièrement avantageux d'utiliser un oscillateur 5 asservi sur le signal d'entrée afin de fournir une image du signal d'entrée qui est plus stable. Cette image pourra alors être comparée dans le comparateur 2 à un autre signal.

Dans un mode de réalisation particulier avec au moins deux sources en plus du générateur G, lorsque le circuit commande 3 détecte par exemple que les premiers et deuxièmes signaux C1 et C2 ne sont plus synchronisés, le générateur de signal d'horloge G n'est plus asservi. Le générateur de signal d'horloge G va donc dériver d'une manière connue définie par son niveau de performance. Il est alors avantageux d'utiliser le signal délivré par le générateur de signal G et de le comparer au premier signal C1 présent sur la première entrée du comparateur 2 et au deuxième signal C2 présent sur la deuxième entrée I2 du comparateur 2 afin de déterminer rapidement lequel de ces deux signaux est pollué.

En comparant le signal émis par le générateur G avec les différents signaux présents sur les entrées I1, I2 du circuit d'arbitrage, le circuit de commande 3 est capable de déterminer facilement quel signal est pollué. Le signal pollué n'est plus pris en compte et l'autre signal peut être comparé au signal d'horloge en provenance du générateur de signal. Le mode de fonctionnement est alors identique à celui décrit dans la figure 1 et présenté plus haut. Le circuit de commande 3 peut être configuré pour rechercher la source de synchronisation défaillante et pour l'exclure par exemple en comparant son signal avec le signal du générateur interne.

Si le circuit d'arbitrage temporel 1 est connecté à deux sources externes de synchronisation, il est avantageux de ne pas synchroniser le générateur de signal G avec la source externe de synchronisation qui est conservée. En effet, une dérive lente et continue de la source externe de synchronisation ne sera pas détectée par le circuit d'arbitrage 1 et pourra entraîner une dérive lente et continue du signal d'horloge de sortie.

En revanche, dans le cas où le circuit d'arbitrage temporel 1 est connecté initialement à trois sources de synchronisation différentes du générateur, l'élimination d'une des sources de synchronisation n'empêche pas la synchronisation du générateur de signal G avec l'une ou l'autre des sources restantes car les deux sources restantes peuvent être testées pour savoir si elles sont synchronisées ou non.

Par exemple, dans un circuit d'arbitrage temporel 1 configuré pour délivrer un signal d'horloge de sortie C_{O} ayant une précision de l'ordre de 10 ns, le circuit de commande 3 peut être configuré pour rejeter une entrée si sa dérive est de l'ordre de 5 ns sur une période de temps de 400 secondes, ce qui correspond sensiblement à une dérive de l'ordre de 1 *µ*s par journée. Une telle règle de réjection correspond à 50 % de la limite d'exactitude du circuit d'arbitrage temporel 1. Une fois que le circuit de commande détecte que les signaux de synchronisation sont désynchronisés, le circuit de commande analyse l'écart entre le signal délivré par le générateur G et les différents signaux présents sur les entrées. Le signal dont la dérive est supérieure à 4,5 ns après 400 secondes d'observation est rejeté. Le circuit peut détecter si les entrées ne sont pas synchronisées et il peut également déterminer l'entrée qui est défaillante.

De manière avantageuse, le circuit de commande 3 est configuré pour que le temps d'observation des différents signaux par rapport au signal délivré par le générateur G soit suffisant pour maintenir 50 % de la limite d'exactitude du circuit d'arbitrage 1. De cette manière, en ayant toléré une excursion égale à 50 % de la limite d'exactitude du circuit d'arbitrage 1, il est possible de détecter et de rejeter une entrée de synchronisation polluée sans affecter la performance du signal de sortie attendue par l'utilisateur.

De manière avantageuse, chaque entrée du circuit d'arbitrage temporel est considérée indépendamment.

De manière avantageuse, les mesures de synchronisation entre les différents signaux sont réalisées sans modifier le générateur G et/ou la source de synchronisation interne ce qui évite d'altérer l'horloge interne du circuit 1 au fur et à mesure des différentes mesures.

De manière avantageuse, les différentes valeurs de la première information D et éventuellement les différentes valeurs des écarts temporels entre les sources sont enregistrées dans une zone mémoire (non représenté). Il est également possible d'enregistrer les différentes actions réalisées sur le générateur G ainsi que sur les autres constituants du circuit d'arbitrage temporel 1. Les données enregistrées dans la zone mémoire peuvent être traitées par le circuit de commande afin de déclencher des actions complémentaires.

Dans un mode de réalisation particulièrement avantageux, le comparateur est configuré pour faire une mesure continue de la synchronisation entre les différents signaux appliqués en entrée du comparateur, par exemple mesurer en continu l'écart temporel entre les différents signaux. L'analyse en continu des différents signaux garantit à l'utilisateur qu'il utilise le signal d'horloge de sortie avec la précision demandée.

Lorsque le circuit de commande 3 autorise la synchronisation du générateur G avec les signaux en provenances des sources de synchronisation, il est avantageux de réaliser la synchronisation en continu afin d'éviter des sauts dans le temps.

En variante, lorsque le circuit de commande 3 autorise la synchronisation du générateur G avec les signaux en provenance des sources de synchronisation, il est avantageux de réaliser la synchronisation de manière périodique afin de détecter des variations dans la dérive entre le générateur G et les sources de synchronisation S1, S2, S3.

Dans une autre variante, lorsque le circuit de commande 3 autorise la synchronisation du générateur G avec les signaux en provenance des sources de synchronisation, il est avantageux de réaliser la synchronisation de manière aléatoire afin de se prémunir d'un acte de malveillance qui ferait évoluer lentement l'une des sources de synchronisation.

De manière avantageuse, le circuit de commande 3 est configuré pour émettre une information représentative de son mode de fonctionnement et/ou des erreurs ou défaillances détectées. Le circuit de commande 3 peut être configuré pour autoriser l'émission d'un ou plusieurs des signaux suivant :
- les différentes sources ne sont pas synchronisées,
- une des sources de synchronisation n'émet plus de signal ou cette source émet un signal qui n'est pas synchronisé avec les autres sources,
- le circuit d'arbitrage recherche le signal non synchronisé,
- le générateur n'est plus asservi à l'une des sources extérieures, c'est-à-dire à l'un des signaux présents sur ses entrées,
- le circuit d'arbitrage a exclu une source de synchronisation.

## Revendications

1. Circuit d'arbitrage temporel (1) comportant :
• un comparateur (2) comportant au moins des première et deuxième entrées et configuré pour fournir au moins une première information (D) relative à l'état de synchronisation des signaux (C1, C2, Ci) présents sur les première et deuxième entrées,
• un générateur de signal d'horloge (G) connecté à une borne de sortie (O) du circuit d'arbitrage temporel et délivrant un signal d'horloge de sortie (Co),
• un circuit de commande (3) configuré pour autoriser ou bloquer la délivrance du signal d'horloge de sortie (Co) sur la borne de sortie (O) en fonction de la au moins une première information (D) du comparateur (2) et/ou pour délivrer une information relative à l'état de synchronisation en fonction de la au moins une première information (D),
• la première entrée du comparateur (2) est connectée à une première borne d'entrée (I1) du circuit d'arbitrage temporel (1) destinée à être connectée à une première source (S1) délivrant un premier signal d'horloge (C1),
• la deuxième entrée du comparateur (2) est destinée à être connectée à une deuxième source (S2, G) délivrant un deuxième signal d'horloge (C2, Ci),
le circuit d'arbitrage temporel (1) **caractérisé en ce que** le comparateur (2) ou le circuit de commande (3) est configuré pour calculer l'évolution d'un écart temporel entre les signaux (C1, C2, Ci) présents sur les première et deuxième entrées et/ou la vitesse d'évolution de l'écart temporel sur une période de temps prédéterminée, la au moins une première information (D) étant obtenue à partir de l'évolution de l'écart temporel et/ou la vitesse d'évolution de l'écart temporel.

2. Circuit d'arbitrage temporel (1) selon la revendication 1, dans lequel le générateur de signal d'horloge (G) est connecté à la deuxième entrée du comparateur (2).

3. Circuit d'arbitrage temporel (1) selon la revendication 1, dans lequel la deuxième entrée du comparateur (2) est connectée à une deuxième borne d'entrée (I2) du circuit d'arbitrage temporel (1) destinée à être connectée à une deuxième source (S2) délivrant le deuxième signal d'horloge (C2), la deuxième source (S2) étant différente du générateur de signal d'horloge (G).

4. Circuit d'arbitrage temporel (1) selon la revendication 3, dans lequel une troisième entrée du comparateur (2) est connectée au générateur de signal d'horloge (G) et dans lequel le circuit de commande (3) est configuré pour :
• synchroniser le générateur de signal d'horloge (G) avec l'un des signaux (S1, S2) appliqués sur les première et deuxième entrées du comparateur (2) lorsque le comparateur (2) fournit la au moins une première information (D) indiquant la synchronisation des signaux (S1, S2) présents sur les première et deuxième entrées,
• empêcher la synchronisation du générateur de signal d'horloge (G) avec l'un des signaux (S1, S2) appliqués sur les première et deuxième entrées du comparateur (2) lorsque le comparateur (2) fournit la au moins une première information (D) indiquant la non-synchronisation des signaux présents sur les première et deuxième entrées.

5. Circuit d'arbitrage temporel (1) selon la revendication 3, dans lequel une troisième entrée du comparateur (2) est destinée à être connectée à une troisième source (S3) délivrant un troisième signal d'horloge, et dans lequel le circuit de commande (3) est configuré pour :
• synchroniser le générateur de signal d'horloge (G) avec l'un des signaux (S1, S2, S3) appliqués sur les première, deuxième et troisième entrées du comparateur (2) lorsque le comparateur (2) fournit la au moins une première information (D) indiquant la synchronisation des signaux (S1, S2, S3) présents sur les première, deuxième et troisième entrées,
• empêcher la synchronisation du générateur de signal d'horloge (G) avec l'un des signaux (S1, S2, S3) appliqués sur les première, deuxième et troisième entrées du comparateur (2) lorsque le comparateur (2) fournit la au moins une première information (D) indiquant la non-synchronisation des signaux (S1, S2, S3) présents sur les première, deuxième et troisième entrées.

6. Circuit d'arbitrage temporel (1) selon la revendication 5, dans lequel la troisième source (S3) ou le générateur de signal d'horloge (G) est choisi parmi les oscillateurs à quartz et les micro-oscillateurs atomiques.

7. Circuit d'arbitrage temporel (1) selon l'une des revendications 4 à 6, dans lequel le générateur de signal d'horloge (G) est synchronisé continûment avec le premier signal d'horloge (C1) ou le deuxième signal d'horloge (C2) lorsque l'écart temporel n'atteint pas une valeur seuil.

8. Circuit d'arbitrage temporel (1) selon l'une des revendications 4 à 6, dans lequel le générateur de signal d'horloge (G) est synchronisé à intervalle régulier avec le premier signal d'horloge (C1) ou le deuxième signal d'horloge (C2) lorsque l'écart temporel n'atteint pas une valeur seuil.

9. Circuit d'arbitrage temporel (1) selon l'une des revendications 4 à 6, dans lequel le générateur de signal d'horloge (G) est synchronisé à intervalle aléatoire avec le premier signal d'horloge (C1) ou le deuxième signal d'horloge (C2) lorsque l'écart temporel n'atteint pas une valeur seuil.

10. Circuit d'arbitrage temporel (1) selon l'une des revendications précédentes, dans lequel le comparateur (2) est configuré pour faire une mesure continue dudit écart temporel.

11. Circuit d'arbitrage temporel (1) selon les revendications 4 ou 5, dans lequel la au moins une première information (D) est obtenue au moyen d'un écart temporel entre les signaux présents sur les première et troisième entrées et/ou d'un écart temporel entre les signaux présents sur les deuxième et troisième entrées.

12. Circuit d'arbitrage temporel (1) selon l'une quelconque des revendications précédentes, dans lequel le circuit de commande (3) est configuré pour arrêter la délivrance du signal d'horloge de sortie (Co) si l'écart temporel atteint une valeur seuil après une durée prédéfinie initiée lorsque le circuit de commande (3) détecte que l'écart temporel a atteint une valeur seuil.

13. Circuit d'arbitrage temporel (1) selon l'une quelconque des revendications précédentes, dans lequel la première entrée (11) destinée à recevoir le premier signal (C1) est connectée à un premier circuit de traitement (4₁) comportant un oscillateur de traitement (5), le premier circuit de traitement (4₁) étant configuré pour asservir l'oscillateur de traitement (5) au signal reçu en entrée de sorte que le premier circuit de traitement (4₁) délivre un signal d'horloge représentatif du signal appliqué sur la première entrée (I1) pour le comparateur (2).

14. Circuit d'arbitrage temporel (1) selon l'une quelconque des revendications précédentes, dans lequel le générateur de signal d'horloge (G) est un oscillateur à quartz ou oscillateur atomique à base de rubidium ou de césium.

15. Circuit d'arbitrage temporel (1) selon l'une quelconque des revendications précédentes, dans lequel le comparateur (2) est formé par une pluralité de comparateurs élémentaires (2a, 2b, 2c), les comparateurs élémentaires (2a, 2b, 2c) étant agencés pour comparer toutes les entrées du comparateur (2) deux à deux.

16. Dispositif de fourniture d'un signal d'horloge comportant un circuit d'arbitrage temporel (1) selon l'une quelconque des revendications précédentes et dans lequel la première source (S1) est formée par un ou plusieurs satellites, par une connexion filaire ou par un signal émis par ondes hertziennes.

## Patentansprüche

1. Zeitarbitrierungsschaltung (1), umfassend:
- einen Komparator (2), umfassend mindestens einen ersten und zweiten Eingang und dafür ausgelegt, um mindestens eine erste Information (D) in Bezug auf den Synchronisationszustand von Signalen (C1, C2, Ci) zu liefern, die an dem ersten und zweiten Eingang vorhanden sind,
- einen Taktsignalgenerator (G), der mit einem Ausgangsanschluss (O) der Zeitarbitrierungsschaltung verbunden ist und ein Ausgangstaktsignal (Co) liefert,
- eine Steuerschaltung (3), die dafür ausgelegt ist, um das Liefern des Ausgangstaktsignals (Co) über den Ausgangsanschluss (O) in Abhängigkeit von der mindestens einen ersten Information (D) des Komparators (2) zu autorisieren oder zu blockieren, und/oder um eine Information in Bezug auf den Synchronisationszustand in Abhängigkeit von der mindestens einen ersten Information (D) zu liefern,
- wobei der erste Eingang des Komparators (2) mit einem ersten Eingangsanschluss (I1) der Zeitarbitrierungsschaltung (1) verbunden ist, der dazu bestimmt ist, mit einer ersten Quelle (S1) verbunden zu werden, die ein erstes Taktsignal (C1) liefert,
- wobei der zweite Eingang des Komparators (2) dazu bestimmt ist, mit einer zweiten Quelle (S2, G) verbunden zu werden, die ein zweites Taktsignal (C2, Ci) liefert,
wobei die Zeitarbitrierungsschaltung (1) **dadurch gekennzeichnet ist, dass** der Komparator (2) oder die Steuerschaltung (3) dafür ausgelegt ist, um die Entwicklung eines Zeitabstands zwischen den Signalen (C1, C2, Ci), die an dem ersten und zweiten Eingang vorhanden sind, und/oder die Geschwindigkeit der Entwicklung des Zeitabstands in einer vorherbestimmten Zeitperiode zu berechnen, wobei die mindestens eine erste Information (D) aus der Entwicklung des Zeitabstands und/oder der Geschwindigkeit der Entwicklung des Zeitabstands erhalten wird.

2. Zeitarbitrierungsschaltung (1) nach Anspruch 1, wobei der Taktsignalgenerator (G) mit dem zweiten Eingang des Komparators (2) verbunden ist.

3. Zeitarbitrierungsschaltung (1) nach Anspruch 1, wobei der zweite Eingang des Komparators (2) mit einem zweiten Eingangsanschluss (I2) der Zeitarbitrierungsschaltung (1) verbunden ist, der dazu bestimmt ist, mit einer zweiten Quelle (S2) verbunden zu werden, die ein zweites Taktsignal (C2) liefert, wobei die zweite Quelle (S2) von dem Taktsignalgenerator (G) verschieden ist.

4. Zeitarbitrierungsschaltung (1) nach Anspruch 3, wobei ein dritter Eingang des Komparators (2) mit dem Taktsignalgenerator (G) verbunden ist, und wobei die Steuerschaltung (3) dafür ausgelegt ist, um:
- den Taktsignalgenerator (G) mit einem der Signale (S1, S2) zu synchronisieren, die an den ersten und zweiten Eingang des Komparators (2) angelegt werden, wenn der Komparator (2) die mindestens eine erste Information (D) liefert, welche die Synchronisation der Signale (S1, S2) anzeigt, die an dem ersten und zweiten Eingang vorhanden sind,
- die Synchronisation des Taktsignalgenerators (G) mit einem der Signale (S1, S2) zu verhindern, die an den ersten und zweiten Eingang des Komparators (2) angelegt werden, wenn der Komparator (2) die mindestens eine erste Information (D) liefert, welche die Nicht-Synchronisation der Signale anzeigt, die an dem ersten und zweiten Eingang vorhanden sind.

5. Zeitarbitrierungsschaltung (1) nach Anspruch 3, wobei ein dritter Eingang des Komparators (2) dazu bestimmt ist, mit einer dritten Quelle (S3) verbunden zu werden, die ein drittes Taktsignal liefert, und wobei die Steuerschaltung (3) dafür ausgelegt ist, um:
- den Taktsignalgenerator (G) mit einem der Signale (S1, S2, S3) zu synchronisieren, die an den ersten, zweiten und dritten Eingang des Komparators (2) angelegt werden, wenn der Komparator (2) die mindestens eine erste Information (D) liefert, welche die Synchronisation der Signale (S1, S2, S3) anzeigt, die an dem ersten, zweiten und dritten Eingang vorhanden sind,
- die Synchronisation des Taktsignalgenerators (G) mit einem der Signale (S1, S2, S3) zu verhindern, die an den ersten, zweiten und dritten Eingang des Komparators (2) angelegt werden, wenn der Komparator (2) die mindestens eine erste Information (D) liefert, welche die Nicht-Synchronisation der Signale (S1, S2, S3) anzeigt, die an dem ersten, zweiten und dritten Eingang vorhanden sind.

6. Zeitarbitrierungsschaltung (1) nach Anspruch 5, wobei die dritte Quelle (S3) oder der Taktsignalgenerator (G) aus Quarzoszillatoren und Atommikrooszillatoren ausgewählt ist.

7. Zeitarbitrierungsschaltung (1) nach einem der Ansprüche 4 bis 6, wobei der Taktsignalgenerator (G) kontinuierlich mit dem ersten Taktsignal (C1) oder dem zweiten Taktsignal (C2) synchronisiert wird, wenn der Zeitabstand einen Schwellenwert nicht erreicht.

8. Zeitarbitrierungsschaltung (1) nach einem der Ansprüche 4 bis 6, wobei der Taktsignalgenerator (G) in regelmäßigen Intervallen mit dem ersten Taktsignal (C1) oder dem zweiten Taktsignal (C2) synchronisiert wird, wenn der Zeitabstand einen Schwellenwert nicht erreicht.

9. Zeitarbitrierungsschaltung (1) nach einem der Ansprüche 4 bis 6, wobei der Taktsignalgenerator (G) in willkürlichen Intervallen mit dem ersten Taktsignal (C1) oder dem zweiten Taktsignal (C2) synchronisiert wird, wenn der Zeitabstand einen Schwellenwert nicht erreicht.

10. Zeitarbitrierungsschaltung (1) nach einem der vorhergehenden Ansprüche, wobei der Komparator (2) dafür ausgelegt ist, um eine kontinuierliche Messung des genannten Zeitabstands vorzunehmen.

11. Zeitarbitrierungsschaltung (1) nach den Ansprüchen 4 oder 5, wobei die mindestens eine erste Information (D) mit Hilfe eines Zeitabstands zwischen den Signalen, die an dem ersten und dritten Eingang vorhanden sind, und/oder eines Zeitabstands zwischen den Signalen, die an dem zweiten und dritten Eingang vorhanden sind, erhalten wird.

12. Zeitarbitrierungsschaltung (1) nach einem der vorhergehenden Ansprüche, wobei die Steuerschaltung (3) dafür ausgelegt ist, um das Liefern des Ausgangstaktsignals (Co) anzuhalten, wenn der Zeitabstand einen Schwellenwert nach einer vorherbestimmten Dauer erreicht, die initiiert wird, wenn die Steuerschaltung (3) detektiert, dass der Zeitabstand einen Schwellenwert erreicht hat.

13. Zeitarbitrierungsschaltung (1) nach einem der vorhergehenden Ansprüche, wobei der erste Eingang (I1), der dazu bestimmt ist, das erste Signal (C1) zu empfangen, mit einer ersten Verarbeitungsschaltung (4₁) verbunden ist, die einen Verarbeitungsoszillator (5) umfasst, wobei die erste Verarbeitungsschaltung (4₁) dafür ausgelegt ist, um den Verarbeitungsoszillator (5) mit dem am Eingang empfangenen Signal derart zu versorgen, dass die erste Verarbeitungsschaltung (4₁) ein Taktsignal, das für das an den ersten Eingang (I1) angelegte Signal repräsentativ ist, für den Komparator (2) liefert.

14. Zeitarbitrierungsschaltung (1) nach einem der vorhergehenden Ansprüche, wobei der Taktsignalgenerator (G) ein Quarzoszillator oder ein Atomoszillator auf der Basis von Rubidium oder von Cesium ist.

15. Zeitarbitrierungsschaltung (1) nach einem der vorhergehenden Ansprüche, wobei der Komparator (2) aus einer Vielzahl von elementaren Komparatoren (2a, 2b, 2c) gebildet ist, wobei die elementaren Komparatoren (2a, 2b, 2c) eingerichtet sind, um alle Eingänge des Komparators (2) paarweise zu vergleichen.

16. Vorrichtung zum Liefern eines Taktsignals, umfassend eine Zeitarbitrierungsschaltung (1) nach einem der vorhergehenden Ansprüche, und wobei die erste Quelle (S1) durch einen oder mehrere Satelliten, durch eine Leitungsverbindung oder durch ein über Funkwellen emittiertes Signal gebildet wird.

## Claims

1. Time arbitration circuit (1) comprising:
• a comparator (2) comprising at least first and second inputs and configured to provide at least a first data item (D) relative to a synchronization status of signals (C1, C2, Ci) present on the first and second inputs,
• a clock signal generator (G) connected to an output terminal (O) of the time arbitration circuit (1) and delivering an output clock signal (C_{O}),
• a control circuit (3) configured to enable or disable delivery of the output clock signal (C_{O}) on the output terminal (O) according to the at least a first data item (D) from the comparator (2) and/or to deliver data relative to the synchronization status according to the at least a first data item (D),
• the first input of the comparator (2) is connected to a first input terminal (11) of the time arbitration circuit (1) designed to be connected to a first source (S1) delivering a first clock signal (C1),
• the second input of the comparator (2) is designed to be connected
to a second source (S2, G) delivering a second clock signal (C2, Ci), time arbitration circuit (1) **characterized in that** the comparator (2) or the control circuit (3) is configured to calculate variation of a time difference between the signals (C1, C2, Ci) present on the first and second inputs and/or the time difference variation rate on a predetermined time period, the at least a first data item (D) being obtained by means of the variation of the time difference and/or the time difference variation rate.

2. Time arbitration circuit (1) according to claim 1, wherein the clock signal generator (G) is connected to the second input of the comparator (2).

3. Time arbitration circuit (1) according to claim 1, wherein the second input of the comparator (2) is connected to a second input terminal (12) of the time arbitration circuit (1) designed to be connected to a second source (S2) delivering the second clock signal (C2), the second source(S2) being different from the clock signal generator (G).

4. Time arbitration circuit (1) according to claim 3, wherein a third input of the comparator (2) is connected to the clock signal generator (G) and wherein the control circuit (3) is configured to:
• synchronize the clock signal generator (G) with one of the signals (S1, S2) applied on the first and second inputs of the comparator (2) when the comparator (2) provides the at least a first data item (D) indicating synchronization of the signals (S1, S2) applied on the first and second inputs,
• preventing synchronization of the clock signal generator (G) with one of the signals (S1, S2) applied on the first and second inputs of the comparator (2) when the comparator (2) provides the at least a first data item (D) indicating non-synchronization of the signals present on the first and second inputs.

5. Time arbitration circuit (1) according to claim 3, wherein a third input of the comparator (2) is designed to be connected to a third source (S3) delivering a third clock signal (C3), and wherein the control circuit (3) is configured to:
• synchronize the clock signal generator (G) with one of the signals (S1, S2, S3) applied on the first, second and third inputs of the comparator (2) when the comparator (2) provides the at least a first data item (D) indicating synchronization of the signals (S1, S2, S3) present on the first, second and third inputs,
• preventing synchronization of the clock signal generator (G) with one of the signals (S1, S2, S3) applied on the first, second and third inputs of the comparator (2) when the comparator (2) provides the at least a first data item (D) indicating non-synchronization of the signals (S1, S2, S3) present on the first, second and third inputs.

6. Time arbitration circuit (1) according to claim 5, wherein the third source (S3) or the clock signal generator (G) is chosen from quartz oscillators and atomic micro-oscillators.

7. Time arbitration circuit (1) according to one of the claims 4 to 6, wherein the clock signal generator (G) is synchronized continuously with the first clock signal (C1) or the second clock signal (C2) when the time difference does not reach the threshold value.

8. Time arbitration circuit (1) according to one of the claims 4 to 6, wherein the clock signal generator (G) is synchronized at regular intervals with the first clock signal (C1) or the second clock signal (C2) when the time difference does not reach a threshold value.

9. Time arbitration circuit (1) according to one of the claims 4 to 6, wherein the clock signal generator (G) is synchronized at random intervals with the first clock signal (C1) or the second clock signal (C2) when the time difference does not reach a threshold value.

10. Time arbitration circuit (1) according to one of preceding claims, wherein the comparator (2) is configured to perform continuous measurement of said time difference.

11. Time arbitration circuit (1) according to claims 4 or 5, wherein the at least a first data item (D) is obtained by means of a time difference between the signals present on the first and third inputs and/or a time difference between the signals present on the second and third inputs.

12. Time arbitration circuit (1) according to any one of preceding claims, wherein the control circuit (3) is configured to stop delivery of the output clock signal (C_{O}) if the time difference reaches a threshold value after a predefined time period started when the control circuit (3) detects that the time difference has reached the threshold value.

13. Time arbitration circuit (1) according to any one preceding claims, wherein the first input (11) designed to receive the first signal (C1) is connected to a first processing circuit (4₁) comprising a processing oscillator (5), the first processing circuit (4₁) being configured to servo-control the processing oscillator (5) to the signal received on input so that the first processing circuit (4₁) delivers a clock signal representative of the signal applied on the first input (11) to the comparator (2).

14. Time arbitration circuit (1) according to any one of preceding claims, wherein the clock signal generator (G) is a quartz oscillator or an atomic oscillator made from a rubidium or caesium base.

15. Time arbitration circuit (1) according to any one of preceding claims, wherein the comparator (2) is formed by a plurality of elementary comparators (2a, 2b, 2c), the elementary comparators (2a, 2b, 2c) being arranged to compare all the inputs of the comparator (2) two by two.

16. Device for providing a clock signal comprising a time arbitration circuit (1) according to any one of preceding claims and wherein the first source (S1) is formed by one or more satellites, by a hard-wired connection or by a signal emitted by radio waves.
